(19) Europäisches Patentamt
European Patent Office
Office européen des brevets

(11) EP 1 883 973 B1

(12) **EUROPEAN PATENT SPECIFICATION**

(45) Date of publication and mention of the grant of the patent:
**30.12.2015 Bulletin 2015/53**

(21) Application number: **06746373.7**

(22) Date of filing: **09.05.2006**

(51) Int Cl.:
***H01L 29/786*** *(2006.01)* ***H01L 51/05*** *(2006.01)*
***H01L 51/00*** *(2006.01)*

(86) International application number:
**PCT/JP2006/309626**

(87) International publication number:
**WO 2006/123596 (23.11.2006 Gazette 2006/47)**

(54) **ORGANIC THIN FILM TRANSISTOR, ACTIVE MATRIX DISPLAY AND FABRICATION METHOD**

OPTISCHER DÜNNFILMTRANSISTOR, AKTIVMATRIX-DISPLAY UND HERSTELLUNGSMETHODE

TRANSISTOR ORGANIQUE À COUCHE MINCE, AFFICHAGE À MATRICE ACTIVE ET MÉTHODE DE FABRICATION

(84) Designated Contracting States:
**DE FR GB IT NL**

(30) Priority: **18.05.2005 JP 2005146047**
**04.04.2006 JP 2006103671**

(43) Date of publication of application:
**06.02.2008 Bulletin 2008/06**

(73) Proprietor: **Ricoh Company, Ltd.**
**Tokyo 143-8555 (JP)**

(72) Inventors:
- **YAMAGA, Takumi**
**Kanagawa, 225-0014 (JP)**
- **TOMONO, Hidenori**
**Kanagawa, 222-0036 (JP)**
- **KAWASHIMA, Ikue**
**Kanagawa, 224-0006 (JP)**

(74) Representative: **Leeming, John Gerard**
**J A Kemp**
**14 South Square**
**Gray's Inn**
**London WC1R 5JJ (GB)**

(56) References cited:
**WO-A2-2005/022664**
**JP-A- 2004 241 701**
**JP-A- 2004 297 011**
**JP-A- 2004 297 011**
**JP-A- 2005 056 871**
**JP-A- 2005 072 135**
**JP-A- 2005 093 633**
**JP-A- 2005 093 633**
**US-A1- 2005 051 780**

- **ANDO MASAHIKO ET AL: "Self-aligned self-assembly process for fabricating organic thin-film transistors" APPLIED PHYSICS LETTERS, AIP, AMERICAN INSTITUTE OF PHYSICS, MELVILLE, NY, US LNKD- DOI: 10.1063/1.1784871, vol. 85, no. 10, 1 January 2004 (2004-01-01), pages 1849-1851, XP012062478 ISSN: 0003-6951**
- **KAWASE T ET AL: "Inkjet printing of polymer thin film transistors" THIN SOLID FILMS, ELSEVIER-SEQUOIA S.A. LAUSANNE, CH LNKD- DOI: 10.1016/S0040-6090(03)00801-0, vol. 438-439, 22 August 2003 (2003-08-22), pages 279-287, XP004448006 ISSN: 0040-6090**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 883 973 B1

## Description

TECHNICAL FIELD

The present invention relates to a thin film transistor having an organic semiconductor layer, an active matrix display using the organic thin film transistor and a method of manufacturing the thin film transistor.

BACKGROUND ART

Extensive study has been made of a thin film transistor using organic semiconductor materials.

Employing organic semiconductor materials in transistors brings the following advantages. 1). It is possible to obtain a large variety of material composition, and obtain high flexibility of the fabricating methods and of the product forms. 2). It is easy to obtain a large area of the transistor. 3). It is possible to simplify the fabricating process with a simplified layer structure. 4). It is possible to reduce the cost of the fabricating apparatus.

Since it is possible to easily form the organic thin film or a circuit by any one of the methods of printing, spin-coating, or dipping, or others, it is possible to fabricate the organic thin film transistor at much lower cost than a semiconductor device based on silicon of the related art.

When integrating organic thin film transistors, it is required to form a pattern as explained below. If the organic thin film transistors are integrated without patterning, when the transistors are in operation, the OFF currents of the transistors increase, and power consumption rises. This may cause cross-talk when using the transistors to display pixels. In the semiconductor device based on silicon of the related technology, this pattern is formed using photolithography process.

As for the organic thin film transistors, inkjet printing is a promising method for the patterning. For example, Japanese Laid Open Patent Application No. 2004-297011 (below, referred to as "reference 1") discloses a method of fabricating an organic thin film transistor by providing charges so as to pattern with the Coulomb force of the charges, thereby resulting in high accuracy and small fluctuations of performance, by patterning with dents, or by patterning with laser exposure.

In addition, for example, Japanese Laid Open Patent Application No. 2004-141856 (below, referred to as "reference 2") discloses a method of patterning a source electrode and a drain electrode involving forming an indent and discharging electrode materials thereon by a recording head of an inkjet device.

When fabricating a pattern of an organic semiconductor layer, the following method may be utilized, which method includes the steps of applying photo resist, exposing and developing a desired pattern, forming a resist pattern, performing etching with the resist pattern as a mask, and removing the resist to form a pattern.

However, when using polymer materials as the organic semiconductor material, if the photo resist is applied on a polymer active layer to form a pattern, the performance of the transistor may be degraded.

In addition, since the photo resist is obtained by dissolving a novolac resin, which has a naphthoquinonediazide as a photosensitive group, in an organic solvent such as xylene and cellosolve solvents, the polymer may be dissolved in the organic solvent included in the photo resist.

When using crystalline materials like pentacene as the organic semiconductor material, more or less performance degradation is confirmed after the photolithography process.

When removing the resist after the photolithography process, the solutions used for removal, such as ethylene glycol monobutyl ether or monoethanolamine, may cause damage, and rinsing with purified water after the removal step with the solutions may also cause damage.

Japanese Laid Open Patent Application No. 2003-536260 (below, referred to as "reference 3") discloses a method of patterning by vacuum deposition, using a shadow mask, of crystalline materials such as pentacene, which is an organic semiconductor material. However, in the method disclosed in reference 3, the size of the pattern is limited by the shadow mask, and it is difficult to form a film of a large area. In addition, the shadow mask has limited product cycle; as a result, it is difficult to reduce the manufacturing cost.

Japanese Laid Open Patent Application No. 2002-540591 (below, referred to as "reference 4") also discloses a method in this field.

When using a polymer material soluble in an organic solvent, it is possible to pattern by inkjet printing. However, considering the landing accuracy of ink droplets, it is difficult to pattern with features less than 50 $\mu$m, and it is difficult to realize fine photolithography.

Returning to the issue of fabricating the organic thin film transistor by inkjet printing, because it is possible to directly perform patterning on a substrate by inkjet printing, the usability of the materials is improved. Thus, when applying the inkjet printing to pattern of the organic semiconductor layer, it is possible to simplify the fabrication process, improve the yield, and reduce the cost.

However, in the inkjet printing, it is difficult to reduce the size of the discharged ink droplet. Thus in order to

further improve the resolution, particularly concerning fabrication of the source electrode and the drain electrode, it is necessary to change the performance of the substrate surface where the ink droplet lands.

Between the source electrode and the drain electrode, in order to obtain a desired current, a pattern a few μm is required. However, when forming a pattern a few μm on the substrate, the electrode material may leak out from electrode pattern region , and this results in failure of patterning , and may cause a short circuit.

Although the pattern can be formed by reducing the size of the discharged ink droplets, this also suffers from some limitations. Further, if considering landing accuracy of the ink droplet in the inkjet printing, namely, the accuracy of discharging the ink droplet, or the accuracy of feeding of the stage where the substrate is placed, it is very difficult to pattern with high accuracy. Of course, even when the material properties of the discharged ink droplet (for example, viscosity, surface tension, dryness) change slightly, these changes may cause discharge bending or tails (ligaments). Due to this, the electrode patterns cannot be formed as desired, and electrical short circuits or disconnection may occur.

WO 2005/022664 discloses a method of producing a metal element of an electronic device on a substrate in which material comprising metal atoms with a liquid is deposited on a substrate then irradiated with light to increase the electrical conductivity of the deposited material.

## DISCLOSURE OF THE INVENTION

The present invention may solve one or more of the problems of the related art.

A preferred embodiment of the present invention may provide an organic thin film transistor having high performance.

According to the present invention, there are provided organic thin film transistors, an active matrix display device and a method of manufacturing said organic thin film transistors as defined in the appended claims.

According to the present invention, it is possible to provide an organic thin film transistor fabricated by using a fine source/drain electrode pattern. When fabricating an organic thin film transistor backplane of an active matrix display device, it is possible to directly draw a precise pattern on the substrate by inkjet printing, and it is possible to simplify the fabrication process, improve the yield, and reduce the cost.

In addition, since the organic insulating film includes polyimide, the surface energy can be modified by ultraviolet ray exposure; thus it is possible to directly draw a precise electrode pattern on the substrate by inkjet printing or dispenser printing.

Preferably, the metal ink is prepared by dispersing fine metal particles, and preferably, the fine metal particles include Au, Ag, Cu, Pt, Pd, Ni, Ir, Rh, Co, Fe, Mn, Cr, Zn, Mo, W, Ru, In, or Sn, or any combination of them. Especially Au, Ag, Cu, and Ni are preferable because they are superior in the electrical resistance, the thermal conductivity, and the corrosion resistance.

The metal ink is fabricated by dispersing fine metal particles having an average particle diameter from a few nm to a few tens nm in a solution uniformly.

It is known that the fine metal particles are sintered at a very low temperature. This is because along with a smaller and smaller particle diameter, the influence of highly active surface atoms prevails. When forming films by inkjet printing using the metal ink and performing sintering, it is possible to directly draw a precise electrode pattern on the substrate.

However, in inkjet printing, it is necessary to consider the material properties of the metal ink. For example, if the surface tension of the metal ink is not appropriate, probably the metal ink cannot be discharged or cannot be discharged correctly. In addition, if the viscosity of the metal ink is not appropriate, the metal ink droplet cannot have a spherical shape, and tails (ligaments) may become long.

Therefore, preferably, the metal ink has the following material properties. Specifically, the surface tension is about 30 mN/m and the viscosity is from about 2 mPa·s to about 13 mPa·s, more preferably, from about 7 mPa·s to about 10 mPa·s. Further, preferably, the metal ink has dryness such that the solvent is not volatilized during the discharge to make the fine metal particles into blocks.

In addition, it is preferable that the gate electrode, the source electrode, and the drain electrode be formed from a conductive polymer material. The conductive polymer material may include polythiophen, polyaniline, polypyrrole, poly-para-phenylene, polyacetylene, or a polymer with these materials doped. Particularly, the complex of polyethylenedioxythiophene (PEDOT) and polystyrene sulfonate (PSS) (the complex is denoted to be "PEDOT/PSS") is preferable because of its good electrical conductivity, stability, and thermal resistance.

Although the conductive polymer material is not as good as the metal ink in electrical characteristics and stability, the electrical characteristics and stability of the conductive polymer material can be improved by the polymerization grade and the structure thereof. Further, because sintering is not necessary for the conductive polymer material, it is possible to reduce the fabrication temperature when using the conductive polymer material.

Further, according to an embodiment of the present invention, by combining an active matrix backplane having the organic thin film transistors and pixel devices , it is possible to fabricate a display panel at low cost and of superior

flexibility.

These and other objects, features, and advantages of the present invention will become more apparent from the following detailed description of preferred embodiments given with reference to the accompanying drawings , in which:

FIG. 1 is a plan view illustrating a conventional electrode pattern;
FIG. 2 is a plan view illustrating an electrode pattern having corners of modified shapes described for reference;
FIG. 3 is a plan view illustrating an electrode pattern according to an embodiment of the present invention;
FIG. 4 shows a relationship between the landing accuracy of the ink droplets and the resolution between the source electrode and the drain electrode;
FIG. 5 is a schematic cross sectional view illustrating a structure of the transistor according to Figure 2;
FIG. 6 shows static characteristics of the transistor of the first example, in which the electrodes are formed from Ag ink and have obtuse-angled corners;
FIG. 7 shows static characteristics of the transistor of Figure 2, in which the electrodes are formed from PEDOT/PSS and have obtuse- angled corners; and
FIG. 8 shows static characteristics of the transistor of the embodiment, in which the electrodes have projecting portions.

Below, preferred embodiments of the present invention are explained with reference to the accompanying drawings.

In the inkjet printing, since it is difficult to reduce the size of the discharged ink droplet, it is necessary to modify the characteristics of the surface of substrate where the ink lands in order to further improve the resolution.

For example, a fine pattern can be formed in the following way. First, watersoluble ink is deposited by inkjet printing on a surface of a substrate including a portion having high surface energy and a portion having low surface energy; then, an ink film is formed only in the portion having the high surface energy. In this way, a fine pattern can be formed.

As described above, when forming the source and drain electrode patterns less than a few μm on the substrate, the electrode material may leak out from the source and drain electrode patterns, resulting in failure of pattern formation and a short circuit.

In order to form the electrode pattern as desired with the discharged electrode materials without occurrence of the short circuit, the electrode pattern can be formed by inkjet printing utilizing the difference of the surface energy of the substrate, and the shape of the electrode can be appropriately modified.

FIG. 1 is a plan view illustrating a conventional electrode pattern.

The electrode pattern shown in FIG. 1 includes source electrodes 1, drain electrodes 2, and gate electrodes 3.

In FIG. 1, the source electrodes 1 and the drain electrodes 2 have rectangular shapes with right angle corners. When the intervals between the source electrode patterns and the drain electrode patterns are a few μm, the electrode materials may contact each other, causing an electrical short circuit, and in turn causing failure of transistor fabrication. There are two possible reasons for this problem. First, due to incorrect ink discharge, fluctuation occurs and the electrode materials are discharged to other places than the electrode formation region. Second, the electrode materials leak out from the object electrode patterns.

The pattern can be formed by reducing the size of the discharged ink droplets with an inkjet device, but the effect is limited. In addition, it is difficult to completely prevent changes of the material properties of the electrode materials, and it is difficult to completely prevent incorrect ink discharge.

Further, the nozzles of the recording head of the inkjet device have small fluctuations, and the electrode materials are discharged to positions deviating from the intended position. In addition, discharge bending occurs due to the changes of the material properties of the electrode materials. These deviated electrode materials may cause an electrical short circuit.

When the source electrodes 1 and the drain electrodes 2 have rectangular shapes of right angle corners, the excessive electrode materials discharged to the electrode patterns tend to gather at the right angle corners where the surface energy is high. For this reason, the electrode material gathered at the right angle corners have contact angles greater than 20 degrees relative to the surface of the substrate, and thus, the electrode materials leak out from the corners. When the intervals between the source electrode patterns and the drain electrode patterns are a few μm, the electrode materials may come into contact with each other, causing an electrical short circuit.

FIG. 2 is a plan view illustrating an electrode pattern having corners of modified shapes.

In order to prevent the leaked electrode materials from coming into contact with each other, as shown in the upper portion in FIG. 2, corners of the ends of the electrodes along the channel region are made into obtuse-angled shapes.

Certainly, as shown in the lower portion in FIG. 2, corners of the ends of the electrodes along the channel region can be made into round shapes (2b) .

When ultraviolet rays are irradiated by using a photo mask, the obtuse-angled shaped portion of the electrode

pattern has high surface energy and other portions have low surface energy.

With such shaped corners, because of the surface energy difference between the high surface energy and the low surface energy, the electrode materials are formed only in the portion having the high surface energy. In other words, for the ink droplets (electrode material) landing in the boundary region between the high surface energy area and the low surface energy area, the ink droplets landing in the area having low surface energy is drawn to flow to the area having high surface energy. The electrode material formed on the electrode pattern flows more or less because of the obtuse-angled effect, and does not gather at the corners; and for the contact angles less than 20 degrees relative to the surface of the substrate, the electrode material does not leak out from the electrode pattern. As a result, it is possible to prevent the embossment of electrode material at the corner of electrode pattern, and improve the flatness of the pattern.

Due to this, it is possible to fabricate a transistor with intervals between the patterns being a few $\mu$m as desired, and improve reliability and yield of the next step.

FIG. 4 shows a relationship between the landing accuracy of the ink droplets and the resolution between the source and the drain electrodes.

When forming the electrode patterns with a usual inkjet device (indicated by triangles in FIG. 4), the improvement of the resolution depends on the landing accuracy of the ink droplets. However, when forming the electrode patterns with an inkjet printing device utilizing the difference of the surface energy (indicated by squares in FIG. 4), because incorrect ink discharge is preventable, the resolution is improved significantly. In addition, when electrodes having obtuse-angled corners are adopted (indicated by diamonds in FIG. 4), it is possible to prevent the leakage of electrode material after landing of the ink droplets, and this further improves the resolution. In the inkjet printing, for example, when the ink droplet is 8 pl (pico liter), even though the landing accuracy is 25 $\mu$m, by utilizing the difference of the surface energy, and further by adopting electrodes having obtuse-angled shaped corners, it is possible to achieve good yield from patterning a 5 $\mu$m channel.

Below, a method of fabricating a transistor of the present example is described.

FIG. 5 is a schematic cross-sectional view illustrating a structure of the transistor according to the present example.

As shown in FIG. 5, on a glass substrate 5, for- example, the gate electrode 3 is formed from A1 or Cr by vacuum deposition, and polyimide is applied on the gate electrode 3 to form an insulating film 6.

Then ultraviolet rays are irradiated on the polyimide insulating film 6 by using a photo mask to form electrode patterns, which patterns are used for subsequently forming the source electrode 1 and the drain electrode 2.

On the thus formed patterns, for example, the source electrode 1 and the drain electrode 2 are formed by printing a PEDOT/PSS solution (PEDOT: polyethylenedioxythiophene, PSS: polystyrene sulfonate) by means of inkjet printing or dispenser printing, and then an organic semiconductor material is applied by spin-coating to form an organic semiconductor layer 4.

In doing so, a transistor as shown in FIG. 5 is formed, which transistor has a stacked structure including the glass substrate 5, the aluminum gate electrode 3, the polyimide insulating film 6, the source electrode 1 and the drain electrode 2 formed from PEDOT/PSS, and the organic semiconductor layer 4.

Below, the characteristics of the thus fabricated transistor are described.

FIG. 7 shows static characteristics of this transistor, in which the electrodes are formed from PEDOT/PSS and have obtuse-angled corners. In FIG. 7, the abscissa represents a gate voltage Vg, and the ordinate represents a drain current-Id.

The Vg-Id characteristics of the transistor as shown in FIG. 7 are described below.

In the ON state (namely, operational state), the drain current -Id = $0.8 \times 10^{-6}$ A. (Specifically, in the ON state, Vg = -20·V.)

In the OFF state (namely, non-operational state), the drain current -Id = $2.5 \times 10^{-10}$ A. (In the OFF state, Vg = 0 V.)

Thus, the ratio of the drain current -Id when Vg = -20 V over the drain current -Id when Vg = 0 V (below, referred to as "ON/OFF ratio") is $3.5 \times 10^{3}$.

This implies that an electrical short circuit does not occur between the source electrode and the drain electrode, and good transistor characteristics are obtained.

The ON state current of a field effect transistor (that is, the operational state current) is expressed as below.

$$Id = W/2L \times \mu \times Ci \times (Vg-Vth)^2$$

Where Id is the drain current (ON state current), W represents a channel width, L represents a channel length, $\mu$ represents mobility, Ci represents a static capacitance of the gate insulating film, Vg represents the gate voltage, and Vth represents a threshold voltage.

In order to increase the drain current (ON state current), it is sufficient to increase the channel width W and

reduce the channel length L. The channel width W depends on the electrode length.

Embodiment

FIG. 3 is a plan view illustrating an electrode pattern according to a an embodiment of the present invention.

In the following, the same reference numbers are assigned to the same or the corresponding elements as those described above.

In the electrode pattern shown in FIG. 3, each electrode includes portions projecting outward for gathering leaked electrode materials, which are formed at positions other than ends of electrodes in contact with the channel regions.

Because of the projecting portions, it is possible to limit the electrode materials gathering at ends of electrodes in contact with the channel regions. Hence, even when the amount of the discharged ink fluctuates, an electrical short circuit does not occur, and the desired electrode pattern can be formed.

The discharged excessive electrode materials are gathered at the projecting portions. Even if the electrode materials leak from the projecting portions, the leaked electrode materials does not influence the characteristics of the transistor at all. Consequently, it is possible to obtain a stable channel width and a stable channel length, and this prevents fluctuations of the characteristics of the transistor. In addition, the length of the drain electrode becomes equal to the channel width, and this allows maximum utilization of the electrode length. Further, since the length of the drain electrode can be increased, in doing so, the channel width also increases, and a large drain current is obtainable.

Next, a method of fabricating the transistor of the present embodiment is explained also with reference to FIG. 5.

As shown in FIG. 5, on the glass substrate 5, for example, the gate electrode 3 is formed from A1 or Cr by vacuum deposition, and polyimide is applied on the gate electrode 3 to form the insulating film 6.

Then ultraviolet rays are irradiated on the polyimide insulating film 6 by using a photo mask to form the projecting patterns as shown in FIG. 3. Due to this treatment, the surface of the projecting patterns is activated. On the thus treated surface of the projecting patterns, for example, the source electrode 1 and the drain electrode 2 are formed by printing PEDOT/PSS (polyethylenedioxythiophene / polystyrene sulfonate) by means of inkjet printing or dispenser printing. Then, an organic semiconductor material is applied by spin-coating to form the organic semiconductor layer 4.

By the above process, a transistor as shown in FIG. 5 is formed, which has a stacked structure including the glass substrate 5, the aluminum gate electrode 3, the polyimide insulating film 6, the source electrode 1 and the drain electrode 2 formed from PEDOT/PSS, and the organic semiconductor layer 4.

Below, the characteristics of the thus fabricated transistor are described.

FIG. 8 shows static characteristics of the transistor of the present embodiment, in which the electrodes have projecting portions.

In FIG. 8, the abscissa represents the gate voltage Vg, and the ordinate represents the drain current -Id.

The Vg-Id characteristics of the transistor as shown in FIG. 8 are described below.

In the ON state (namely, an operational state), the drain current -Id = $1.6 \times 10^{-6}$ A. (Specifically, in the ON state, Vg = -20 V.)

In the OFF state (namely, non-operational state), the drain current -Id = $3.2 \times 10^{-10}$ A. (in the OFF state, Vg = 0 V.)

Thus, the ratio of the drain current -Id when Vg = -20 V over the drain current -Id when Vg = 0 V (below, referred to as "ON/OFF ratio") is $5.3 \times 10^3$.

This implies that an electrical short circuit does not occur between the source electrode and the drain electrode, and good transistor characteristics are obtained. Further, since the channel width is increased, a large drain current is obtained.

Embodiment

In this embodiment, the organic semiconductor layer 4 is formed from a nonorientation polymer material having a triaryl amine structure.

In the following, the same reference numbers are assigned to the same or the corresponding elements as those described above.

As shown in FIG. 5, on the glass substrate 5, for example, an A1 film is formed by vacuum deposition, and the select line and the gate electrode 3 are formed by photolithography and etching processes. Then, polyimide is applied on the gate electrode 3 to a thickness of 500 nm acting as the insulating film 6 and the interlayer insulating film of the select line and the data line.

Then, exposure of ultraviolet rays is performed on the polyimide insulating film 6 by using a photo mask to form the electrode patterns. Due to this treatment, the surface of the patterns is activated. On the thus treated surface of the patterns, for example, a PEDOT/PSS film is formed by inkjet printing to form the source electrode 1 and the drain electrode 2, and the data line.

Then, an organic semiconductor material, such as a nonorientation polymer material having a triaryl amine

structure, is discharged by inkjet printing to form the organic semiconductor layer 4.

Then, a poly-para-xylylene film serving as a passivation layer is deposited on the organic semiconductor layer 4 by chemical vapor deposition to a thickness of 2000 nm.

By the above process, an organic thin film transistor backplane as shown in FIG. 5 is formed.

Further, an ITO (Indium Tin Oxide) film is formed by sputtering to a thickness of 100 nm on another substrate , and further an oriented film is formed by spin coating to a thickness of 200 nm. After orientation treatment, the other substrate and the organic thin film transistor backplane are bonded with silica spacers, and then a liquid crystal material is poured and sealed in the gap between the two substrates, thus forming a liquid crystal panel.

In addition to the liquid crystal panel, other kinds of display panels may also be formed with the substrate of the present embodiment.

For example, after the ITO film is formed on the other substrate, the other substrate and the organic thin film transistor backplane are bonded with silica spacers, and then, an electrophoresis material is poured and sealed in the gap between the two substrates, thus forming an electrophoresis display panel.

Further, if organic EL (electroluminescence) devices are formed to serve as display pixels, and an air shield layer is provided, it is possible to form an organic EL display panel.

Below, specific examples are explained.

<u>Example 1</u> (not forming part of the invention)

Referring to FIG. 5 again, on a glass substrate 5 an Al film is deposited by vacuum deposition using a shadow mask to a thickness of 50 nm to serve as the gate electrode 3.

Then, polyimide is applied on the gate electrode 3 by spin-coating to a thickness of 250 nm and is baked to 280 °C, thus forming the polyimide insulating film 6.

Then, an ultraviolet lamp (having a dose of 10 $J/cm^2$) is used to irradiate the polyimide insulating film 6 by using a photo mask to form patterns each having high surface energy. These patterns are used as electrodes each having obtuse-angled corners.

By inkjet printing, Ag ink is discharged onto the patterns having a high surface energy, and is sintered at 280 °C, thus forming the source electrode 1 and the drain electrode 2. The interval between the source electrode 1 and the drain electrode 2 is 5 μm.

Next, a film of an organic semiconductor material, such as triaryl amine expressed by the following chemical formula is applied by spin coating, and is dried. The thickness of the organic semiconductor material film is 30 nm.

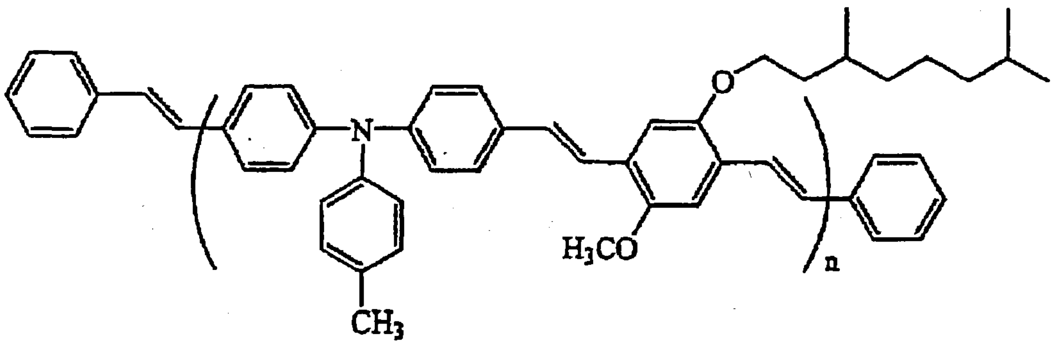

As shown in FIG. 5, the thus fabricated transistor has a stacked structure including the glass substrate 5, the aluminum gate electrode 3, the polyimide insulating film 6 (thickness 250 nm), the source electrode 1 and the drain electrode 2 formed from Ag, and the organic semiconductor layer 4.

The static characteristics of the thus fabricated transistor are as shown in FIG. 6.

FIG. 6 shows static characteristics of the transistor of the present example, in which the electrodes are formed from Ag ink and have obtuse-angled corners. In FIG. 6, the abscissa represents a gate voltage Vg, and the ordinate represents a drain current-Id.

Specifically, in the ON state (Vg = -20 V), the drain current -Id = 0.9 x $10^{-6}$ A; in the OFF state (Vg = 0 V), the drain current -Id = 5.0 x $10^{-11}$ A. Thus, the ON/OFF ratio (the ratio of the drain current -Id with Vg = -20 V over the drain current -Id with Vg = 0 V) is 1.8 x $10^4$. This implies that an electrical short circuit does not occur between the source electrode and the drain electrode, and good transistor characteristics are obtained.

Example 2 (not forming part of the invention)

Referring to FIG. 5 again, on a glass substrate 5 an Al film is deposited by vacuum deposition using a shadow mask to a thickness of 50 nm to serve as the gate electrode 3.
Then, polyimide is applied on the gate electrode 3 by spin-coating to a thickness of 250 nm and is baked to 280 °C, thus forming the polyimide insulating film 6.
Then, an ultraviolet lamp (having a dose of 10 J/cm$^2$) is used to irradiate the polyimide insulating film 6 by using a photo mask to form patterns each having high surface energy. These patterns are used as electrodes each having obtuse-angled corners.
By inkjet printing, a PEDOT/PSS solution is discharged onto the patterns having high surface energy, and is dried at 120 °C, thus forming the source electrode 1 and the drain electrode 2. The interval between the source electrode 1 and the drain electrode 2 is 5 $\mu$m.
Next, a film of an organic semiconductor material, such as triaryl amine expressed by the above chemical formula is applied by spin coating, and is dried. The thickness of the organic semiconductor material film is 30 nm.
As shown in FIG. 5, the thus fabricated transistor has a stacked structure including the glass substrate 5, the aluminum gate electrode 3, the polyimide insulating film 6 (thickness 250 nm), the source electrode 1 and the drain electrode 2 formed from PEDOT/PSS, and the organic semiconductor layer 4.
The static characteristics of the thus fabricated transistor are as shown in FIG. 7.
Specifically, in the ON state (Vg = -20 V), the drain current -Id = 0.8 x $10^{-6}$ A; in the OFF state (Vg = 0 V), the drain current -Id = 2.5 x $10^{-10}$ A. Thus, the ON/OFF ratio (the ratio of the drain current -Id with Vg = -20 V over the drain current -Id with Vg = 0 V) is 3.5 x $10^3$. This implies that an electrical short circuit does not occur between the source electrode and the drain electrode, and good transistor characteristics are obtained.

Example 3 (according to the invention)

In this example, the pattern is formed in a different way from the example 1.
The other steps are the same as the example 1.
When forming the electrode patterns, an ultraviolet lamp (having a dose of 10 J/cm$^2$) is used to irradiate the polyimide insulating film 6 by using a photo mask to form patterns each pattern having high surface energy. These patterns are shaped to have projecting portions.
The thus fabricated transistor has a stacked structure including the glass substrate 5, the aluminum gate electrode 3, the polyimide insulating film 6 (thickness 250 nm), the source electrode 1 and the drain electrode 2 formed from PEDOT/PSS, and the organic semiconductor layer 4.
The static characteristics of the transistor are as shown in FIG. 8.
Specifically, in the ON state (Vg = -20 V), the drain current -Id = 1.6 x $10^{-6}$ A; in the OFF state (Vg = 0 V), the drain current -Id = 3.2 x $10^{-10}$ A. Thus, the ON/OFF ratio (the ratio of the drain current -Id with Vg = -20 V over the drain current -Id with Vg = 0 V) is 5.3 x $10^3$. This implies that an electrical short circuit does not occur between the source electrode and the drain electrode, and good transistor characteristics are obtained. In addition, since the electrode length (namely, the channel width) is increased, a large drain current is obtained.

## Claims

**1.** An organic thin film transistor, comprising:

a substrate;
a gate electrode;
a gate insulating film;
a source electrode on the gate insulating film;
a drain electrode on the gate insulating film at an interval with the source electrode to form a channel region; and
an organic semiconductor layer;
wherein
the gate insulating film includes an electrode formation region having surface energy increased by energy deposition, **characterised in that**
the source electrode or the drain electrode has in plan view two projecting acute-angled corners joining a side thereof which is parallel to the channel region, said acute-angled corners and said side facing away from the channel region.

2. The organic thin film transistor as claimed in claim 1, wherein at least one of the source electrode and the drain electrode has substantially the same shape as a portion of the gate insulating film which portion has an increased surface energy.

3. The organic thin film transistor as claimed in claim 1, wherein the gate insulating film is an organic insulating film formed from a polymer material.

4. The organic thin film transistor as claimed in claim 3, wherein the organic insulating film includes a polyimide film.

5. The organic thin film transistor as claimed in claim 1, wherein the gate electrode, the source electrode, and the drain electrode are formed from metal ink obtained by dispersing metal fine particles.

6. The organic thin film transistor as claimed in claim 5, wherein the metal fine particles include at least one of Au, Ag, Cu, and Ni as a main component.

7. The organic thin film transistor as claimed in claim 1, wherein the gate electrode, the source electrode, and the drain electrode are formed from a conductive polymer material.

8. The organic thin film transistor as claimed in claim 7, wherein the conductive polymer material includes polyethylenedioxythiophene.

9. The organic thin film transistor as claimed in claim 1, wherein the organic semiconductor layer is formed from a polymer material having a triaryl amine structure.

10. An active matrix display device, comprising:

    a plurality of pixels, each pixel having an organic thin film transistor according to any one of the preceding claims as an active device.

11. A method of manufacturing an organic thin film transistor, the transistor comprising a substrate, a gate electrode, a gate insulating film, a source electrode on the gate insulating film, a drain electrode on the gate insulating film at an interval with the source electrode and an organic semiconductor layer, the method comprising:

    locally modifying the surface energy of the gate insulating film by energy deposition to form an electrode formation region; and
    forming the source electrode and/or the drain electrode by inkjet printing or dispenser printing in the electrode formation region so as to have substantially the same shape thereas; **characterised in that**:

        the electrode formation region has in plan view two projecting acute-angled corners joining a side thereof which is parallel to the channel region, said acute-angled corners and said side facing away from a channel region formed by the interval between the drain and source electrodes.

12. The method of manufacturing an organic thin film transistor as claimed in claim 11, wherein the portion of the gate insulating film having the increased surface energy is formed by irradiation of ultraviolet rays.

13. The method of manufacturing an organic thin film transistor as claimed in claim 11 , wherein the organic semiconductor layer is formed by inkjet printing or dispenser printing.

## Patentansprüche

1. Organischer Dünnschichttransistor, der umfasst:

    ein Substrat;
    eine Gate-Elektrode;
    eine Gate-Isolierschicht;
    eine Source-Elektrode auf der Gate-Isolierschicht;
    eine Drain-Elektrode auf der Gate-Isolierschicht in einem Abstand von der Source-Elektrode, um einen Kanalbereich zu bilden; und
eine organische Halbleiterschicht;
wobei
die Gate-Isolierschicht einen Elektrodenformationsbereich enthält, dessen Oberflächenenergie durch Energiedeposition erhöht ist, **dadurch gekennzeichnet, dass**
die Source-Elektrode oder die Drain-Elektrode in einer Draufsicht zwei vorstehende spitzwinkelige Ecken besitzt, die sich mit einer ihrer Seiten verbinden, die zu dem Kanalbereich parallel ist, wobei die spitzwinkeligen Ecken und die Seite von dem Kanalbereich abgewandt sind.

**2.** Organischer Dünnschichttransistor nach Anspruch 1, wobei die Source-Elektrode und/oder die Drain-Elektrode im Wesentlichen dieselbe Form wie ein Abschnitt der Gate-Isolierschicht, der eine erhöhte Oberflächenenergie besitzt, haben.

**3.** Organischer Dünnschichttransistor nach Anspruch 1, wobei die Gate-Isolierschicht eine organische Isolierschicht ist, die aus einem Polymermaterial gebildet ist.

**4.** Organischer Dünnschichttransistor nach Anspruch 3, wobei die organische Isolierschicht eine Polyimidschicht enthält.

**5.** Organischer Dünnschichttransistor nach Anspruch 1, wobei die Gate-Elektrode, die Source-Elektrode und die Drain-Elektrode aus Metalltinte gebildet sind, die durch Verteilen von feinen Metallteilchen erhalten wird.

**6.** Organischer Dünnschichttransistor nach Anspruch 5, wobei die feinen Metallteilchen mindestens eines von Au, Ag, Cu und Ni als eine Hauptkomponente enthalten.

**7.** Organischer Dünnschichttransistor nach Anspruch 1, wobei die Gate-Elektrode, die Source-Elektrode und die Drain-Elektrode aus einem leitenden Polymermaterial gebildet sind.

**8.** Organischer Dünnschichttransistor nach Anspruch 7, wobei das leitende Polymermaterial Polyethylendioxythiophen enthält.

**9.** Organischer Dünnschichttransistor nach Anspruch 1, wobei die organische Halbleiterschicht aus einem Polymermaterial mit einer Triarylaminstruktur gebildet ist.

**10.** Anzeigevorrichtung mit Aktivmatrix, die umfasst:

mehrere Pixel, wobei jedes Pixel einen organischen Dünnschichttransistor nach einem der vorhergehenden Ansprüche als aktive Vorrichtung besitzt.

**11.** Verfahren zum Herstellen eines organischen Dünnschichttransistors, wobei der Transistor ein Substrat, eine Gate-Elektrode, eine Gate-Isolierschicht, eine Source-Elektrode auf der Gate-Isolierschicht, eine Drain-Elektrode auf der Gate-Isolierschicht in einem Abstand von der Source-Elektrode und eine organische Halbleiterschicht umfasst, wobei das Verfahren umfasst:

lokales Ändern der Oberflächenenergie der Gate-Isolierschicht durch Energiedeposition, um einen Elektrodenformationsbereich zu bilden;
Bilden der Source-Elektrode und/oder der Drain-Elektrode durch Tintenstrahldrucken oder Dispenser-Drucken in dem Elektrodenformationsbereich, damit sie dort im Wesentlichen dieselbe Form besitzt; **dadurch gekennzeichnet, dass**:

der Elektrodenformationsbereich in einer Draufsicht zwei vorstehende spitzwinkelige Ecken besitzt, die sich mit einer ihrer Seiten verbinden, die parallel zu dem Kanalbereich ist, wobei die spitzwinkeligen Ecken und die Seite von einem Kanalbereich abgewandt sind, der durch den Abstand zwischen der Drain- und der Source-Elektrode gebildet wird.

**12.** Verfahren zum Herstellen eines organischen Dünnschichttransistors nach Anspruch 11, wobei der Abschnitt der Gate-Isolierschicht, der die erhöhte Oberflächenenergie besitzt, durch Bestrahlen mit Ultraviolettstrahlen gebildet wird.

13. Verfahren zum Herstellen eines organischen Dünnschichttransistors nach Anspruch 11, wobei die organische Halbleiterschicht durch Tintenstrahldrucken oder Dispenser-Drucken gebildet wird.

**Revendications**

1. Transistor à mince film organique, comprenant :

    un substrat ;
    une électrode de grille ;
    un film isolant de grille ;
    une électrode de source sur le film isolant de grille ;
    une électrode de drain sur le film isolant de grille à un intervalle avec l'électrode de source pour former une région de canal ; et
    une couche de semi-conducteur organique ;
    dans lequel
    le film isolant de grille comprend une région de formation d'électrode ayant une énergie de surface augmentée par un dépôt d'énergie, **caractérisé en ce que**
    l'électrode de source ou l'électrode de drain présente dans une vue de dessus deux coins à angles aigus saillants joignant un côté de celle-ci qui est parallèle à la région de canal, lesdits coins à angles aigus et ledit côté se faisant face en partant de la région de canal.

2. Transistor à mince film organique selon la revendication 1, dans lequel au moins une de l'électrode de source et de l'électrode de drain présente pratiquement la même forme qu'une portion du film isolant de grille dont une portion présente une énergie de surface augmentée.

3. Transistor à mince film organique selon la revendication 1, dans lequel le film isolant de grille est un film isolant organique formé à partir d'un matériau polymère.

4. Transistor à mince film organique selon la revendication 3, dans lequel le film isolant organique comprend un film de polyimide.

5. Transistor à mince film organique selon la revendication 1, dans lequel l'électrode de grille, l'électrode de source, et l'électrode de drain sont formées à partir d'une encre de métal obtenue par dispersion de fines particules de métal.

6. Transistor à mince film organique selon la revendication 5, dans lequel les fines particules de métal comprennent au moins un parmi Au, Ag, Cu, et Ni comme un constituant principal.

7. Transistor à mince film organique selon la revendication 1, dans lequel l'électrode de grille, l'électrode de source, et l'électrode de drain sont formées à partir d'un matériau polymère conducteur.

8. Transistor à mince film organique selon la revendication 7, dans lequel le matériau polymère conducteur comprend du polyéthylène-dioxythiophène.

9. Transistor à mince film organique selon la revendication 1, dans lequel la couche de semi-conducteur organique est formée à partir d'un matériau polymère présentant une structure triarylamine.

10. Dispositif d'affichage à matrice active, comprenant :

    une pluralité de pixels, chaque pixel présentant un transistor à mince film organique selon l'une quelconque des revendications précédentes comme un dispositif actif.

11. Procédé de fabrication d'un transistor à mince film organique, le transistor comprenant un substrat, une électrode de grille, un film isolant de grille, une électrode de source sur le film isolant de grille, une électrode de drain sur le film isolant de grille à un intervalle avec l'électrode de source et une couche de semi-conducteur organique, le procédé comprenant :

    la modification locale de l'énergie de surface du film isolant de grille par dépôt d'énergie pour former une région

de formation d'électrode ; et
la formation de l'électrode de source et/ou de l'électrode de drain par impression par jet d'encre ou impression par dispersion dans la région de formation d'électrode afin de présenter pratiquement la même forme que celle-ci ; **caractérisé en ce que** :

la région de formation d'électrode présente dans une vue de dessus deux coins à angles aigus saillants joignant un côté de celle-ci qui est parallèle à la région de canal, lesdits coins à angles aigus et ledit côté étant opposés à partir d'une région de canal formée par l'intervalle entre les électrodes de drain et de source.

**12.** Procédé de fabrication d'un transistor à mince film organique selon la revendication 11, dans lequel la portion du film isolant de grille présentant l'énergie de surface augmentée est formée par irradiation de rayons ultraviolets.

**13.** Procédé de fabrication d'un transistor à mince film organique selon la revendication 11, dans lequel la couche de semi-conducteur organique est formée par impression par jet d'encre ou impression par dispersion.

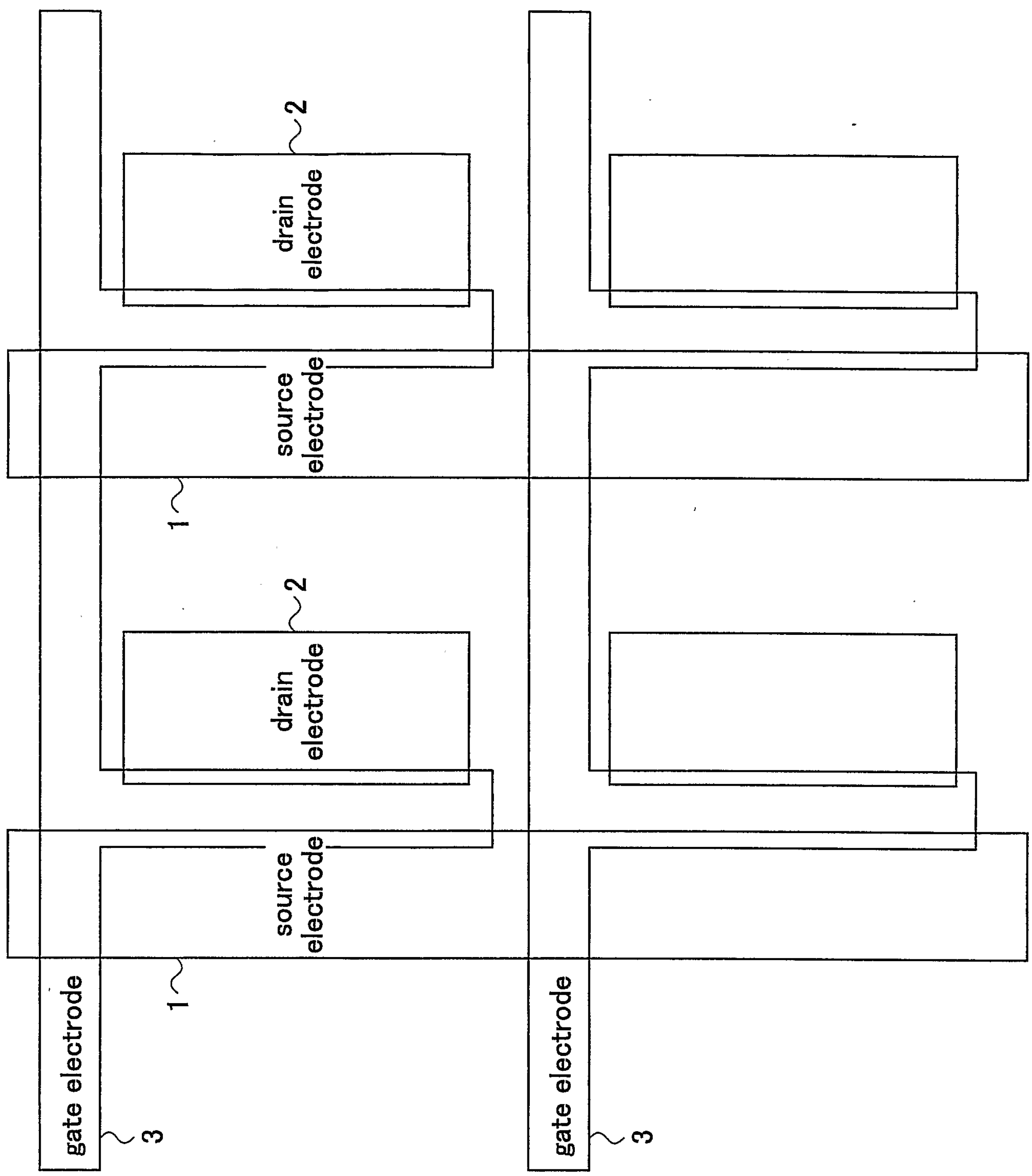
drain electrode
2
source electrode
1
drain electrode
2
source electrode
1
gate electrode
3
gate electrode
3

FIG.1

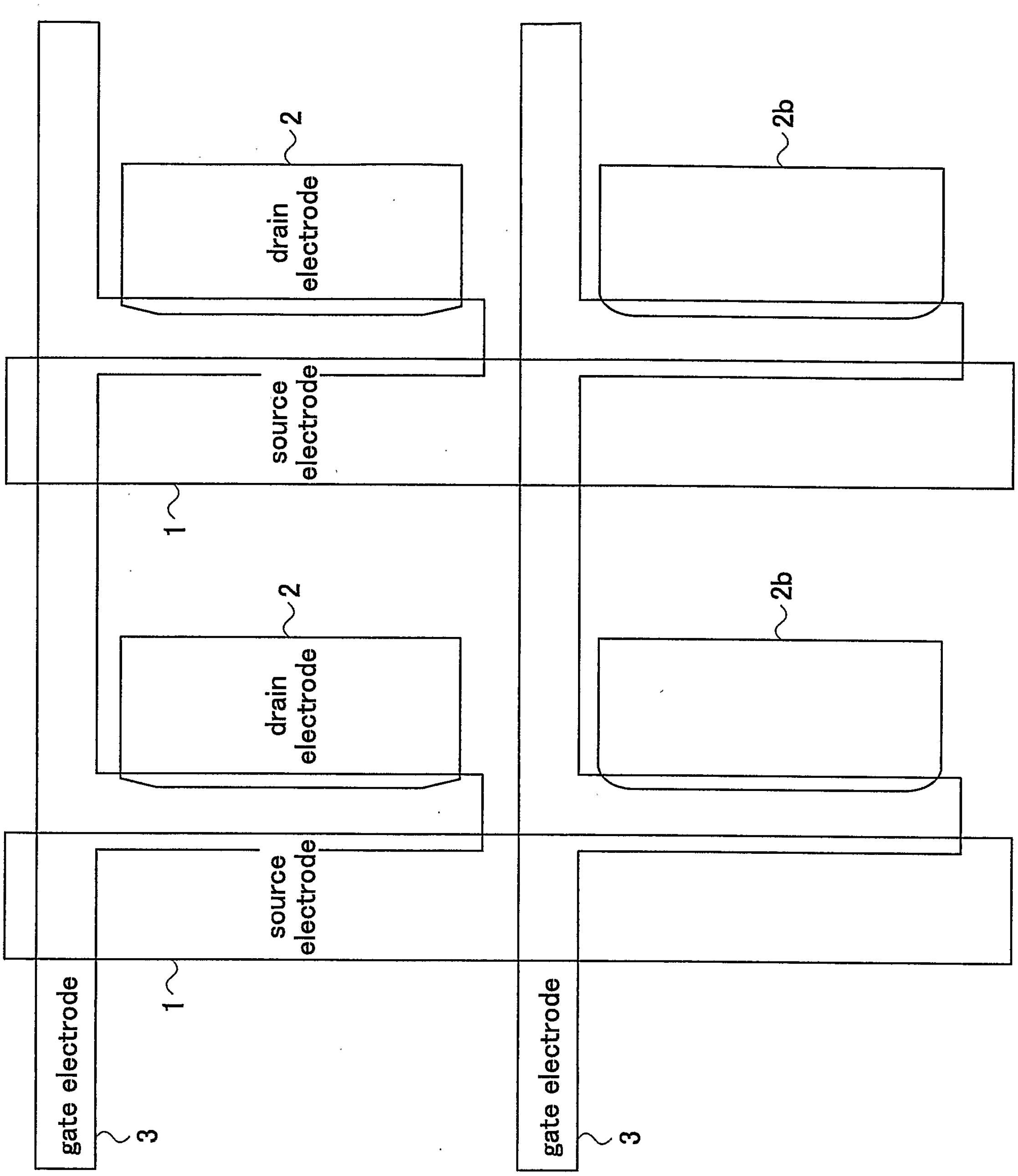
2
drain electrode
2b
source electrode
1
2
drain electrode
2b
source electrode
1
gate electrode
3
gate electrode
3

FIG.2

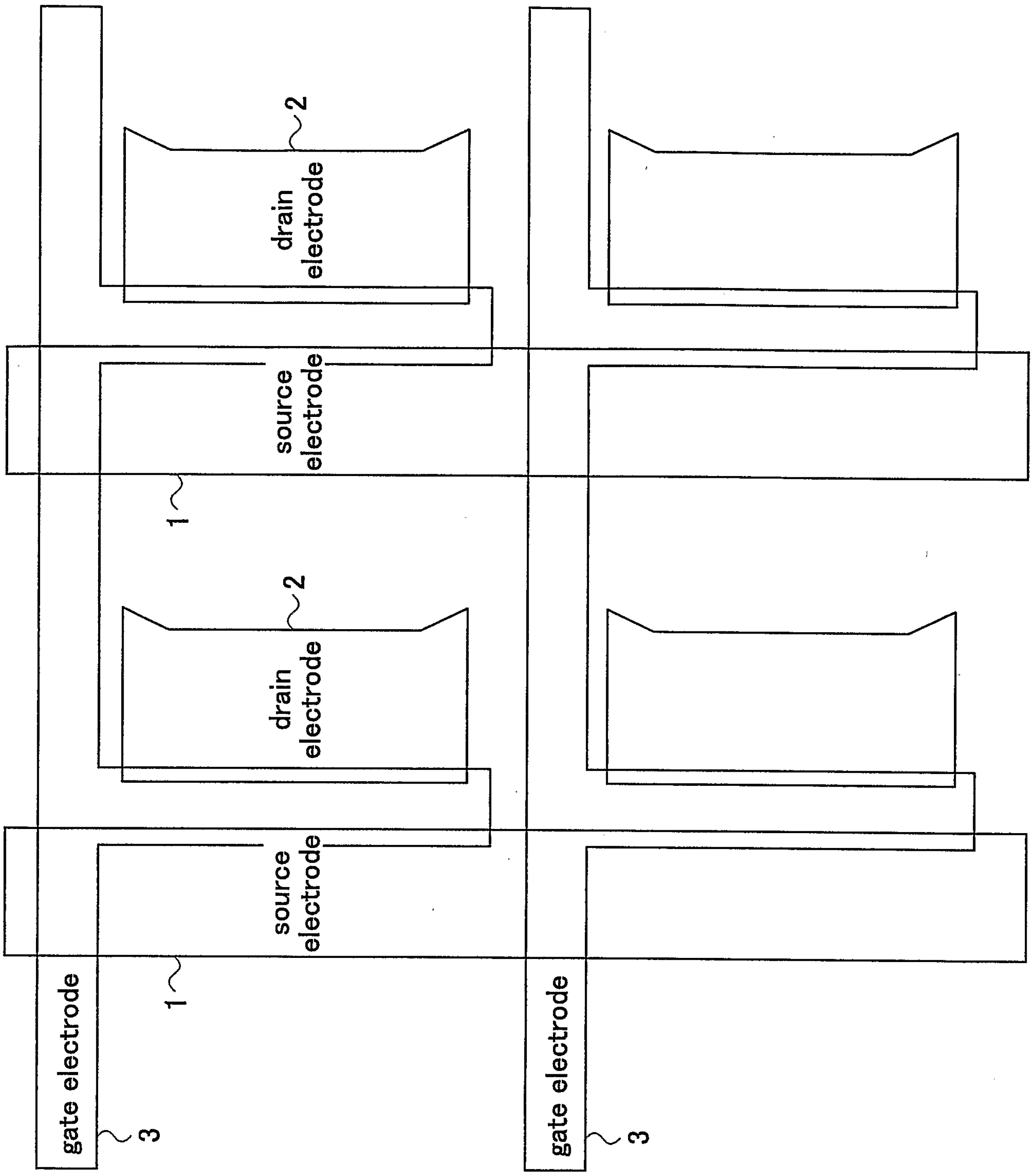
2
drain electrode
source electrode
1
2
drain electrode
source electrode
1
gate electrode
3
gate electrode
3

FIG.3

FIG.4

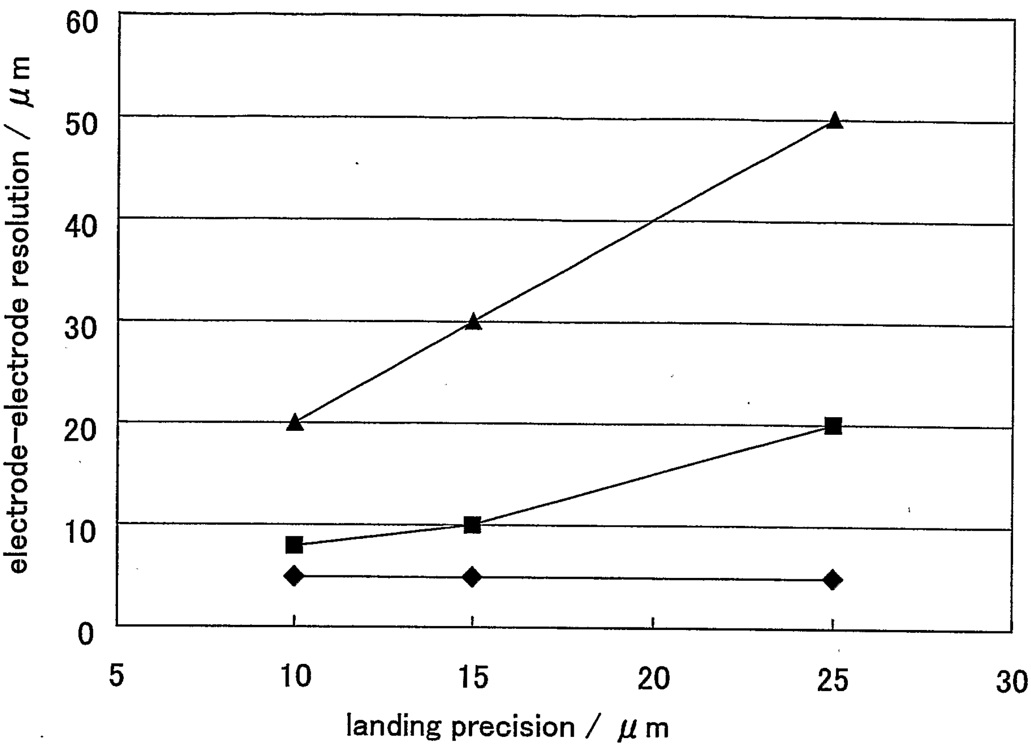
60
50
40
30
20
10
0
5
10
15
20
25
30
electrode-electrode resolution / μm
landing precision / μm

FIG.5

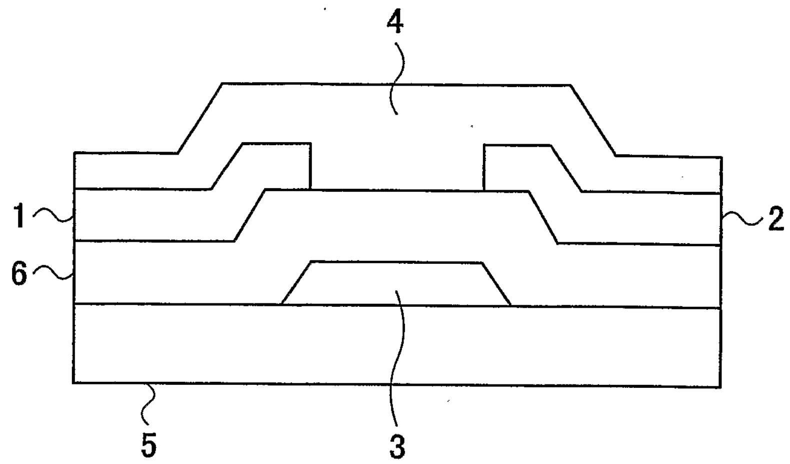
4
1
2
6
5
3

FIG.6

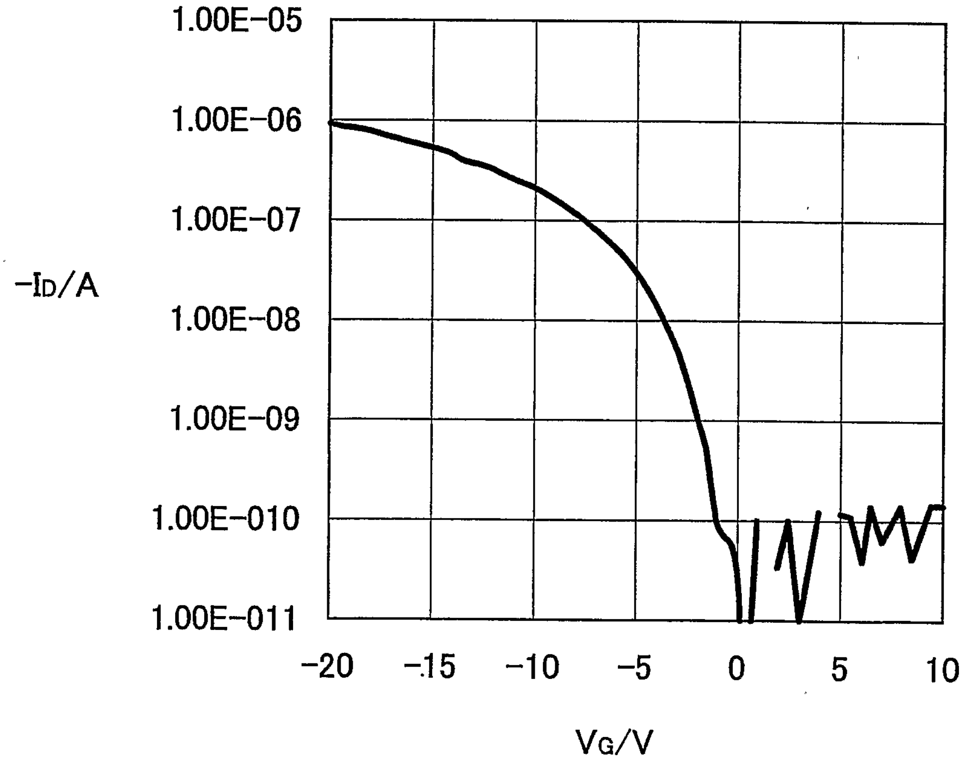
1.00E-05
1.00E-06
1.00E-07
-ID/A
1.00E-08
1.00E-09
1.00E-010
1.00E-011
-20
-15
-10
-5
0
5
10
VG/V

FIG.7

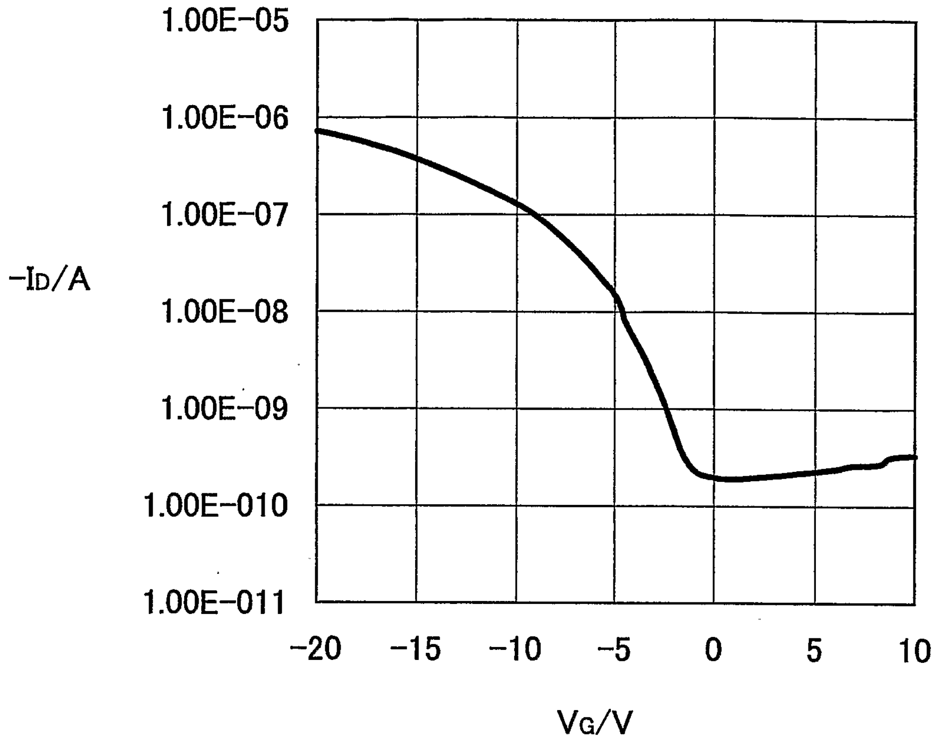
1.00E-05
1.00E-06
1.00E-07
-ID/A
1.00E-08
1.00E-09
1.00E-010
1.00E-011
-20
-15
-10
-5
0
5
10
VG/V

FIG.8

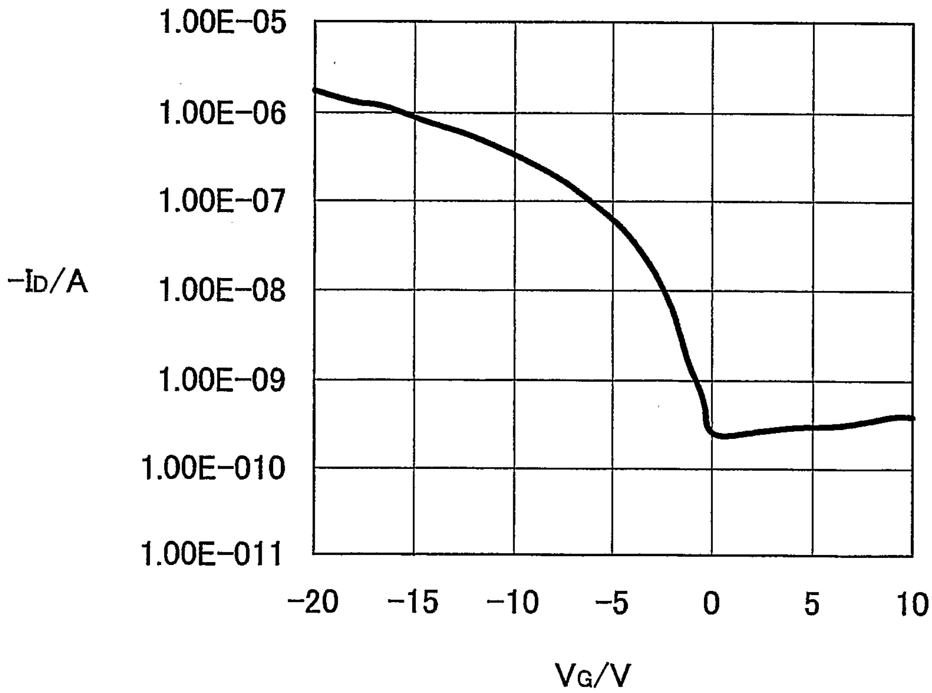
1.00E-05
1.00E-06
1.00E-07
-ID/A
1.00E-08
1.00E-09
1.00E-010
1.00E-011
-20
-15
-10
-5
0
5
10
VG/V

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2004297011 A
- JP 2004141856 A
- JP 2003536260 A
- JP 2002540591 A
- WO 2005022664 A